# EUROPÄISCHE PATENTSCHRIFT

(11) **EP 4 530 942 B1**
(45) Veröffentlichungstag und Bekanntmachung des Hinweises auf die Patenterteilung: **13.08.2025**
(21) Anmeldenummer: 23200113.1
(22) Anmeldetag: 27.09.2023
(51) Int. Cl.: G05B 17/02, G05B 19/418, G05D 1/243, G05D 1/246, G05D 1/698, G06Q 10/04, G06Q 10/08, G05D 109/10, G05D 111/10, G05D 105/28, G05D 107/70

(54) **ERZEUGEN EINES UMGEBUNGSMODELLS**
GENERATING AN ENVIRONMENT MODEL
GÉNÉRATION D'UN MODÈLE D'ENVIRONNEMENT

(43) Veröffentlichungstag der Anmeldung: 02.04.2025
(73) Patentinhaber: SICK AG, 79183 Waldkirch (DE)
(72) Erfinder: Hofmann, Dr. Christoph, 79108 Freiburg (DE); Gebauer, Jens, 79183 Waldkirch (DE); Arockiaraj, Alfred, 79183 Waldkirch (DE)

(56) Entgegenhaltungen:
- DE-A1- 102021 133 614
- DE-A1- 102022 103 730

## Beschreibung

Die Erfindung betrifft ein Verfahren und ein System zum Erzeugen eines Umgebungsmodells einer Umgebung in einer Industrie- oder Logistikanlage nach dem Oberbegriff von Anspruch 1 beziehungsweise 15.

Die Erzeugung eines Umgebungsmodells wird auch als Umgebungsvirtualisierung bezeichnet und bekommt im industriellen Umfeld eine immer größere Bedeutung. Dabei besteht der Wunsch, großflächige Umgebungen zu berücksichtigen und beispielsweise ganze Anlagen, Lagerhallen, Fabrikhallen oder Logistikzentren zu virtualisieren. Die Informationen über die Umgebung können in übergeordneten Prozesssteuerungen verwendet werden, etwa in ein Flottenmanagement-System für autonome Fahrzeuge (wie AGC, Autonomous Guided Container; AGV, Autonomous Guided Vehicle; AMR, Autonomous Mobile Robot) einfließen. Für ein Flottenmanagement steht beispielsweise das Open Robotics Middleware Framework (Open-RMF) als kostenloses, quelloffenes, modulares Softwaresystem zur Verfügung, das die gemeinsame Nutzung und Interoperabilität zwischen mehreren Roboterflotten und der physischen Infrastruktur wie Türen, Aufzügen und Gebäudemanagementsystemen ermöglicht.

In den herkömmlichen Lösungen wird das Umgebungsmodell durch fest verbaute Infrastruktur-Sensorik gespeist. Dazu sind zahlreiche Sensoren, vorwiegend Kameras, in Rastern unter der Hallendecke beziehungsweise an wichtigen Stellen wie Kreuzungen oder Eingängen zu verdeckten Fahrwegen anzubringen. Das erfordert einen hohen Montageaufwand und lässt keine dynamische Anpassung zu. Ein anschauliches Beispiel ist ein Hochregallager mit seinen zahlreichen schmalen Gängen, die nur von eng gerasterten beziehungsweise eigens je Gang angebrachten Kameras erfasst werden können.

Zusätzlich zu den oben genannten autonomen Fahrzeugen sind mittlerweile auch sogenannte Micro-AMRs verfügbar. Das sind besonders kleine und leichte autonome mobile Roboter, die mit Kameras ausgerüstet sind. Sie werden aber bislang im industriellen Umfeld nicht eingesetzt und kämen als Ersatz für die oben genannten autonomen Fahrzeuge nicht in Betracht, da sie keine oder jedenfalls keine nennenswerte Nutzlast tragen können.

Neural Radiance Fields (NeRF) bezeichnet eine Technologie, mit der auf Basis von tiefen neuronalen Netzen eine 3D-Szene rekonstruiert werden kann. In einem inversen Rendering wird das Verhalten von Licht in der realen Welt angenähert. Als Eingangsdaten werden lediglich einige wenige 2D-Bilder und deren unterschiedliche Aufnahmewinkel benötigt. Die Rekonstruktion erfordert nur Sekunden, synthetische Ansichten der 3D-Szene werden in wenigen Millisekunden erzeugt. Als ein grundlegendes Dokument wird die Arbeit von Mildenhall, Ben, et al, "NeRF: Representing scenes as neural radiance fields for view synthesis", Communications of the ACM 65.1 (2021): 99-106 genannt.

Die US 2004/0030571 A1 offenbart ein System mit Gruppen von automatischen mobilen Roboterfahrzeugen (MRV) zur militärischen Aufklärung im Feindesgebiet. Die dabei identifizierten Ziele werden angegriffen. Diese Roboterfahrzeuge sind offensichtlich für den Einsatz im industriellen Umfeld weder gedacht noch geeignet.

In der US 9 747 502 B2 wird eine Cloud-basierte Überwachung mit mindestens zwei fliegenden Drohnen vorgestellt. Damit sollen schwer zugängliche Bereiche überwacht werden, oder Orte, an denen keine fixe Montage einer Kamera möglich ist. Für eine Koordination der Drohnen auf engstem Raum im industriellen Umfeld ist diese Überwachung nicht ausgelegt.

Die US 8 903 551 B2 befasst sich mit einer Ereignisdetektion in einem Rechenzentrum. Fest montierte Temperatursensoren erkennen ein Leck im Kühlsystem, und daraufhin wird ein mobiler Sensor an den betreffenden Ort geschickt, um genauere Informationen zu erfassen. Dieses Vorgehen ist auf ein festes Netz der Temperatursensoren angewiesen, und trotz dieses Installationsaufwands wäre damit eine von der US 8 903 551 B2 ohnehin nicht diskutierte Umgebungsvirtualisierung gar nicht möglich, da nur Temperaturen beziehungsweise weitergehende Informationen nur an einem selektiven Ort erfasst werden.

Die DE 10 2022 103 730 A1 beschreibt ein System zur digitalen Repräsentation eines Waren- und/oder Materiallagers. Eine Sensorik auf einem Flurförderzeug erfasst Informationsdaten, die von einer Recheneinheit verarbeitet werden, um einen digitalen Zwilling des Waren- und/oder Materiallagers zu erzeugen und so eine Art Echtzeit-Inventur durchzuführen.

Die DE 10 2021 133 614 A1 offenbart ein Verfahren zur Erzeugung einer Umgebungskarte für einen mobilen Logistik-Roboter, der die Umgebung mittels einer Sensorik erfasst. Aus den Sensordaten werden Objekte erkannt und klassifiziert, und daraus wird eine Umgebungskarte mit statischen, manipulierbaren und dynamischen Objekten erstellt.

Es ist daher Aufgabe der Erfindung, die Erzeugung eines Umgebungsmodells in einem industriellen Umfeld zu verbessern.

Diese Aufgabe wird durch ein Verfahren und ein System zum Erzeugen eines Umgebungsmodells einer Umgebung in einer Industrie- oder Logistikanlage nach Anspruch 1 beziehungsweise 15 gelöst. Das Umgebungsmodell kann auch als Umgebungsvirtualisierung oder digitaler Zwilling der Umgebung bezeichnet werden und umfasst beispielsweise dreidimensionale Umgebungsinformationen, wie eine dreidimensionale Umgebungskontur, oder daraus abgeleitete Informationen, wie mögliche Fahrwege, feste und bewegliche Objekte und/oder Personen. Die Umgebung befindet sich in einem Gebäude, ist damit eine Indoor-Umgebung beispielsweise eines Logistikzentrums, einer Lagerhalle oder einer Fabrikhalle. Das Erzeugen eines Umgebungsmodells kann die Erststellung insgesamt, das Hinzufügen neuer Bereiche und/oder eine Aktualisierung umfassen. Zumindest die Aktualisierung erfolgt vorzugsweise in Echtzeit, wobei je nach Anwendung eine gewisse Latenz unschädlich und daher erlaubt ist.

Das Umgebungsmodell wird aus den Sensordaten einer Vielzahl über die Umgebung verteilter Sensoren erzeugt. Vorzugsweise sind das optoelektronische Sensoren, insbesondere Kameras und/oder LIDARs. Die Sensoren erfassen ihren jeweiligen lokalen Teilbereich der Umgebung. Daraus wird das Umgebungsmodell zusammengesetzt. Dabei können Sensorinformationen und/oder bereits lokal aus Sensordaten erzeugte Teilmodelle gesammelt und zusammengesetzt werden.

Die Erfindung geht von dem Grundgedanken aus, statt der bisher eingesetzten Infrastruktur-Sensorik mit ihren statisch montierten Sensoren einen Schwarm von mobilen Sensoren einzusetzen. Damit kann das Urngebungsmodell dynamisch aktualisiert werden. Dafür bewegen sich in der Umgebung eine Vielzahl autonomer mobiler Aufklärungseinheiten, die auch als Agenten bezeichnet werden. Diese führen die Sensoren mit sich zu wechselnden Orten in der Umgebung. Dabei ist eine Eins-zu-Eins-Zuordnung zwischen Sensor und Aufklärungseinheit bevorzugt, aber nicht zwingend. Eine Aufklärungseinheit kann mehrere Sensoren mit sich führen, und umgekehrt kann eine Aufklärungseinheit ohne Sensor beziehungsweise mit inaktivem Sensor beispielsweise als Reserve vorgesehen sein. Es müssen auch nicht sämtliche Sensoren, die zu dem Umgebungsmodell beitragen, von Aufklärungseinheiten bewegt werden, ein Hybrid aus statischen und mobilen Sensoren ist denkbar. Der Begriff Schwarm suggeriert mit Absicht eine größere Anzahl als bevorzugte Ausführungsform, wobei aber insbesondere in kleineren Umgebungen bereits einige wenige mobile Aufklärungseinheiten genügen können. Die Aufklärungseinheiten sind vorzugsweise kleine und agile autonome mobile Fahrzeuge beziehungsweise Roboter.

Das Verfahren ist ein computerimplementiertes Verfahren. Es läuft beispielsweise in den Steuerungen der Aufklärungseinheiten, der Sensoren und/oder einer übergeordneten Steuerung ab, insbesondere einem Edge-Device oder einer Cloud.

Die Erfindung hat den Vorteil, dass gleichsam im Wortsinne durch Schwarmintelligenz hochflexibel ein besonders genaues und aktuelles Umgebungsmodell gewonnen wird. Der Aufwand dafür ist gegenüber einer fest verbauten Infrastruktur-Sensorik erheblich reduziert, und der Schwarm an Aufklärungseinheiten kann sehr einfach bedarfsgerecht skaliert und dadurch an geänderte Anwendungsbedingungen oder Umgebungen angepasst werden. Durch den variablen Aufenthaltsort und die sich stetig ändernde Perspektive wird das Problem der Zentralperspektive bei fix installierter Infrastruktur-Sensorik automatisch umgangen, was schon für sich erhebliche technische wie wirtschaftliche Vorteile mit sich bringt. Die Aufklärungseinheiten sind kostengünstig. Es geht, anders als im Falle von autonomen Fahrzeugen für die Logistik oder fliegenden Drohnen, keine Gefahr für in der Nähe arbeitende Personen von ihnen aus, so dass sie kein eigenes Schutzkonzept benötigen. Erforderlichenfalls kann eine Aufklärungseinheit sich verstecken oder ausreichend Abstand halten, damit keine Person stolpert oder ausrutscht. Eine einzelne Aufklärungseinheit hat keinen fest einzuhaltenden Arbeitsablauf, der für den Betrieb der Anlage kritisch ist und durch derartige Ausweichaktionen gestört würde.

Die Aufklärungseinheiten weisen ein Gewicht von höchstens einem Kilogramm, laterale Abmessungen von höchstens 30cm und/oder eine Höhe von 30 Cm auf, , insbesondere mit lateralen Abmessungen von höchstens 20 cm und/oder einer Höhe von höchstens 10 cm. Sie sind vorzugsweise als Micro-ARM ausgebildet. Micro-ARMs können als fertige Einheiten zu geringen Kosten erworben werden. Sie sind klein, leicht und beweglich. Beispielsweise wiegen sie nur wenige Kilogramm, vorzugsweise höchstens ein Kilogramm oder nur einige hundert Gramm. Die lateralen Abmessungen, also Breite und Länge, sind bevorzugt durch einige zehn Zentimeter angegeben, beispielsweise höchstens zwanzig Zentimeter, die Höhe kann in gleicher Weise oder noch stärker auf höchstens zehn oder nur wenige Zentimeter beschränkt sein. Es soll eigens betont sein, dass ein Micro-ARM ein Fahrzeug und damit insbesondere kein fliegendes Objekt wie eine Drohne ist. Im Gegensatz zu einem herkömmlichen in industriellen Umgebungen eingesetzten autonomen Fahrzeug ist ein Micro-ARM nicht in der Lage, Nutzlasten zu befördern, mit der möglichen Ausnahme kleinster Objekte wie Schrauben, Notizzettel, USB-Sticks oder dergleichen.

In der Umgebung bewegt sich eine Vielzahl von mobilen Arbeitseinheiten zum Transport von Nutzlasten, insbesondere autonome Fahrzeuge oder autonome mobile Roboter, wobei eine Arbeitseinheit ein Vielfaches der Größe und/oder des Gewichts einer Aufklärungseinheit aufweist. Die erste Anzahl der Aufklärungseinheiten und die zweite Anzahl der Arbeitseinheiten sind unabhängig voneinander und allenfalls zufällig gleich. Die Arbeitseinheiten bilden gleichsam einen zweiten Schwarm von autonomen beweglichen Einheiten, Fahrzeugen oder Robotern. Im Gegensatz zu den Aufklärungseinheiten, die vorzugsweise Micro-ARMs und jedenfalls klein und hochbeweglich sind, handelt es sich bei den mobilen Arbeitseinheiten um herkömmliche autonome Fahrzeuge wie einleitend diskutiert, die in Industrie- und Logistikeinheiten zur Beförderung von Objekten und Nutzlasten eingesetzt werden. Arbeitseinheiten sind damit deutlich größer und schwerer als die Aufklärungseinheiten und können Nutzlasten von jedenfalls mehreren Kilogramm, vorzugsweise mehreren zehn Kilogramm, mehreren hundert Kilogramm oder sogar noch mehr transportieren. Arbeitseinheiten können ebenfalls Sensoren tragen, um sich selbst zu orientieren beziehungsweise zu navigieren, und deren Sensordaten können dazu beitragen, das Sensormodell zu speisen, aber das ist nicht die primäre Rolle der Arbeitseinheiten.

Die Arbeitseinheiten können sich vorzugsweise in der Umgebung nur auf vorgesehenen Wegen bewegen, insbesondere in Gängen zwischen feststehenden Objekten oder Regalen. Arbeitseinheiten sind jedenfalls unter Einbeziehung der von ihnen transportierten Objekte relativ groß und schwer. Ihre Bewegung ist daher nach dieser Ausführungsform auf bestimmte mögliche Fahrwege beschränkt, sei es aufgrund von Vorgaben, wie Führungsschienen, Markierungen oder Anweisungen eines übergeordneten Systems, oder schlicht physischen Beschränkungen wie auf Gänge in einem Hochregallager.

Die Aufklärungseinheiten sind vorzugsweise nicht an die vorgesehenen Wege gebunden und können sich insbesondere unter einem Regal hindurchbewegen. Aufklärungseinheiten sind klein und wendig, sie können sich nahezu überall bewegen. Sie können beispielsweise unter Hochregalen einfach hindurchfahren und dadurch Gänge rasch wechsein oder Fahrrouten gänzlich unabhängig von Gängen wählen. In fundamentalem Gegensatz zu den Arbeitseinheiten müssen sich also die Aufklärungseinheiten nicht an einen Grundriss einer Umgebung oder Halle halten. Sie sind damit besonders schnell und flexibel und auch in der Lage, sich auf veränderte Umgebungsbedingungen einzustellen. Das Gesamtbild, das sich ergibt, ist ein erster Schwarm von kleinen, hochflexiblen Aufklärern, die weitgehend frei und reaktionsschnell die Umgebung abfahren und damit das Umgebungsmodell aktuell halten, und ein zweiter Schwarm von größeren Arbeitern, die das Umgebungsmodell nutzen, um trotz ihrer beschränkten Beweglichkeit und limitierten Fahrwege effizient die eigentliche Industrie- oder Logistikaufgabe der Umgebung zu unterstützen.

Vorzugsweise bewegt sich zumindest eine Aufklärungseinheit zufällig oder regelbasiert in der Umgebung, insbesondere zum Erfassen eines zugewiesenen Bereichs der Umgebung oder der gesamten Umgebung. Die Aufklärungseinheiten befinden sich folglich ständig auf Patrouillenfahrten, ohne damit gelegentliche Pausen oder ein Stehenbleiben zur vorübergehenden Beobachtung aus einer festen Perspektive auszuschließen. Durch zufällige Bewegung wird die gesamte Umgebung immer wieder aktualisiert, mit zeitlichen Höchstabständen zwischen den Besuchen eines jeden Teils der Umgebung, die sich statistisch hauptsächlich in Abhängigkeit von der Anzahl Aufklärungseinheiten und deren Geschwindigkeit ergeben. Alternativ können Regeln für die Bewegung vorgegeben werden, vorzugsweise im Sinne einer Selbstorganisation in Form nur der jeweiligen Aufklärungseinheit vorgegebener Regeln, die in ihrer Gesamtheit dafür sorgen, dass die Umgebung zyklisch abgerastert wird.

Zumindest eine Aufklärungseinheit bewegt sich vorzugsweise in Reaktion auf ein Ereignis an eine dem Ereignis zugehörige Position in der Umgebung, insbesondere zu einer Person, einer Arbeitseinheit oder einem Hindernis. Personen sind stets besonders vor Unfällen zu schützen, eine Arbeitseinheit kann ein Problem etwa mit ihrer Bewegung, Navigation oder verlorener Ladung haben oder sogar gemeldet haben, Arbeitseinheiten können sich stauen oder sich unerwartete Objekte an unerwarteter Position befinden und dergleichen mehr. Ein solches Ereignis bedeutet, dass in dessen Umgebung ein aktuelles Umgebungsmodell wichtiger ist als eine Aktualisierung irgendwo oder flächendeckend. Es kann also sinnvoll sein, dass mindestens eine Aufklärungseinheit ihr übliches Bewegungsmuster unterbricht und gezielt das Ereignis und dessen Umgebung beobachtet, sei es vorübergehend aus einer festen Position oder durch auf den Bereich des Ereignisses beschränkte Bewegungsmuster.

Die Bewegungen mindestens einiger der Aufklärungseinheiten werden vorzugsweise untereinander abgestimmt. Das ist eine gezielte Abweichung von einer rein autonomen Bewegung, um ein möglichst aktuelles und genaues Umgebungsmodell zu bilden. Beispielsweise kann eine Aufklärungseinheit ein bestimmtes Teilgebiet für sich reklamieren, das dann keine andere Aufklärungseinheit besuchen muss. Ein anderes Beispiel ist eine Absprache, welche Aufklärungseinheit oder Aufklärungseinheiten auf ein Ereignis reagieren, um in der ansonsten vorzugsweise immer wieder zyklisch flächendeckenden Erfassung der Umgebung kein zu großes Loch zu reißen. Um solche Löcher beziehungsweise deren praktische Relevanz zu verhindern, können den von den Aufklärungseinheiten erfassten Daten Zeitstempel oder eine Art Verfallsdatum gegeben werden, damit der Schwarm rechtzeitig aufgefordert werden kann, in den betreffenden Regionen neue Daten zu erfassen. Es ist auch möglich, dass der ganze Schwarm der Aufklärungseinheiten zentral aus einem übergeordneten System gesteuert und koordiniert wird.

Bevorzugt wird ein dreidimensionales Umgebungsmodell aus 2D-Aufnahmen der Sensoren mittels eines neuronalen Netzes erzeugt, insbesondere mittels NeRF (Neural Radiance Fields). Das ist eine Möglichkeit, mit nur ganz wenigen 2D-Aufnahmen ein zunächst lokales dreidimensionales Umgebungsmodell zu erhalten. Damit ist eine besonders schnelle und vollständige Erfassung oder Aktualisierung des Umgebungsmodells möglich. Die erforderlichen Technologien wurden einleitend kurz erläutert.

Bevorzugt erzeugen die Aufklärungseinheiten selbst aus ihren Sensordaten ein Teilmodell des Umgebungsmodells. Prinzipiell wäre auch der andere Weg denkbar, die Sensordaten aller Aufklärungseinheiten zentral zu sammeln und dann daraus das Umgebungsmodell zu erzeugen. Eine verteilte Erzeugung hat aber den Vorteil, dass weniger Daten zu übertragen und die erforderlichen Rechenkapazitäten in günstiger Weise in kleineren Einheiten zur Verfügung gestellt werden können. Eine bevorzugte Architektur sieht die Aufklärungseinheiten als Edge Device vor, insbesondere setzen die Aufklärungseinheiten im Falle der Verwendung eines neuronalen Netzes beziehungsweise von NeRF Methoden der Edge Al ein. Durch dezentrale Auswertung der Sensordaten ergibt sich auch die Möglichkeit einer Anonymisierung direkt an der Quelle, um den Datenschutz zu gewährleisten, also die bevorzugte Erzeugung eines anonymisierten Teilmodells. Das von der Aufklärungseinheit weitergegebene Teilmodell des Umgebungsmodells enthält dann beispielsweise eine Person, aber keine identifizierbare bestimmte Person.

Das Umgebungsmodell wird bevorzugt auf einem Edge-Device oder in einer Cloud zusammengesetzt. Prinzipiell können die Aufklärungseinheiten ihre Sensordaten oder Teilmodelle des Umgebungsmodells jedem beliebigen übergeordneten System liefern. Eine Cloud passt jedoch besonders gut in eine moderne Architektur, insbesondere wenn die Aufklärungseinheiten dazu passend mit Methoden der Edge Al arbeiten. In diesem Zusammenhang ist dann ebenso ein Edge-Device als Alternative oder Ergänzung einer Cloud zu nennen.

Bevorzugt wird ein anfängliches Umgebungsmodell der Umgebung erzeugt, insbesondere in einer Phase ohne Bewegung von Arbeitseinheiten und/oder ohne Personen. Auf diese Weise gibt es einen recht verlässlichen Ausgangspunkt, von dem aus das Umgebungsmodell dann im späteren Betrieb nach und nach durch die jeweiligen lokalen Beobachtungen aktualisiert und gegebenenfalls um neu zugängliche Bereiche erweitert wird. Für die Gewinnung des anfänglichen Umgebungsmodells steht mehr Zeit zur Verfügung, erst im Betrieb ist eine dynamische Aktualisierung möglichst in Echtzeit erwünscht. Eine Möglichkeit, das anfängliche Umgebungsmodell zu gewinnen, ist die Beobachtung durch die Aufklärungseinheiten über eine gewisse Zeitspanne. Da eine Industrie- oder Logistikumgebung üblicherweise sehr genau geplant ist, steht das anfängliche Umgebungsmodell womöglich in Form eines CAD-Modells oder dergleichen schon aus anderer Quelle zur Verfügung. Das anfängliche Umgebungsmodell kann auch als Referenz fungieren, gegenüber der dann im nachfolgenden Betrieb neue Objekte, Personen und sonstige Veränderungen erkannt werden. Vorzugsweise wird das anfängliche Umgebungsmodell segmentiert. Damit kann es weiter strukturiert werden, beispielsweise in Fahrwege, feste Objekte wie Wände oder Regale, momentane Positionen von Arbeitseinheiten, bewegliche Objekte wie Paletten, Ladungen und dergleichen.

Die Aufklärungseinheiten erkennen vorzugsweise Personen in der Umgebung. Aus Sicht der funktionalen Sicherheit, letztlich der Unfallvermeidung, sind Personen besonders wichtige Aspekte des Umgebungsmodells. So können beispielsweise Aufenthaltsorte von Personen in Zeitreihen gespeichert werden, um daraus eine Heatmap der Aufenthaltswahrscheinlichkeit zu erzeugen. Die Routen der Arbeitseinheiten können dann so geplant werden, dass Bereiche erhöhter Aufenthaltswahrscheinlichkeit möglichst gemieden werden, um die Sicherheit latent zu erhöhen. Ein ausreichendes Sicherheitskonzept ist das noch nicht, die Arbeitseinheiten müssen für eine funktionale Sicherheit weitere Maßnahmen zur Kollisionsvermeidung treffen. Aber bereits durch eine Tendenz zur Meidung von Bereichen mit Personen kommt es von Anfang an seltener zu sicherheitskritischen Situationen, was auch die Verfügbarkeit der Anlage insgesamt erhöht. Wie schon erwähnt, bedürfen die Aufklärungseinheiten selbst keines Sicherheitskonzepts, da sie wegen ihres Gewichts und ihrer Größe kaum in der Lage sind, eine Person zu schädigen. Eine noch verbleibende Stolpergefahr fällt nicht unter Maschinensicherheit und kann auch durch großzügige Abstände der Aufklärungseinheiten zu Personen oder das rechtzeitige Verschwinden unter einem Objekt oder Regal stark reduziert oder eliminiert werden.

Ein übergeordnetes System weist bevorzugt in Abhängigkeit von dem Umgebungsmodell den Arbeitseinheiten Fahrwege zu und/oder gibt Personen Hinweise auf Wege. Das übergeordnete System, das dasselbe sein kann wie dasjenige, das das Umgebungsmodell zusammensetzt oder alternativ das Umgebungsmodell lediglich nutzt, ist beispielsweise ein Prozessleitsystem. Dank des aktuellen Umgebungsmodells ist eine besonders gute Wegeplanung möglich. Nochmals bildlich gesprochen kundschaftet der erste Schwarm der Aufklärungseinheiten die Umgebung aus, damit der zweite Schwarm der Arbeitseinheiten besonders effektiv eingesetzt werden kann. Auf ähnliche Weise können Personen in der Umgebung gesteuert werden. An die Stelle direkter Steuerungsanweisungen treten hier Hinweise, beispielsweise Richtungspfeile oder Ampeln.

Das erfindungsgemäße System zum Erzeugen eines Umgebungsmodells einer Umgebung in einer Industrie- oder Logistikanlage weist eine Vielzahl von über die Umgebung verteilte Sensoren zum Erfassen eines jeweiligen lokalen Teilbereichs der Umgebung auf und ist dafür ausgebildet, aus den Sensordaten der Sensoren das Umgebungsmodell zusammenzusetzen. Das System weist weiterhin eine Vielzahl autonomer mobiler Aufklärungseinheiten auf, insbesondere autonome mobile Roboter, die sich in der Umgebung bewegen, und zumindest einige der Sensoren sind Teil einer mobilen Aufklärungseinheit und erfassen somit die Umgebung an wechselnden Orten. Das System kann entsprechend den erläuterten Ausführungsformen des Verfahrens weiter ausgestaltet werden.

Die Erfindung wird nachstehend auch hinsichtlich weiterer Merkmale und Vorteile beispielhaft anhand von Ausführungsformen und unter Bezug auf die beigefügte Zeichnung näher erläutert. Die Abbildungen der Zeichnung zeigen in:
- Fig. 1: eine Darstellung eines Systems mit einer Vielzahl von Aufklärungseinheiten, Arbeitseinheiten und einer übergeordneten Steuerung;
- Fig. 2: eine schematische Übersichtsdarstellung einer industriellen Umgebung mit sich darin bewegenden Aufklärungseinheiten und Arbeitseinheiten;
- Fig. 3: eine Illustration der Umgebung aus Sicht der Aufklärungseinheiten; und
- Fig. 4: eine Illustration der Umgebung aus Sicht der Arbeitseinheiten.

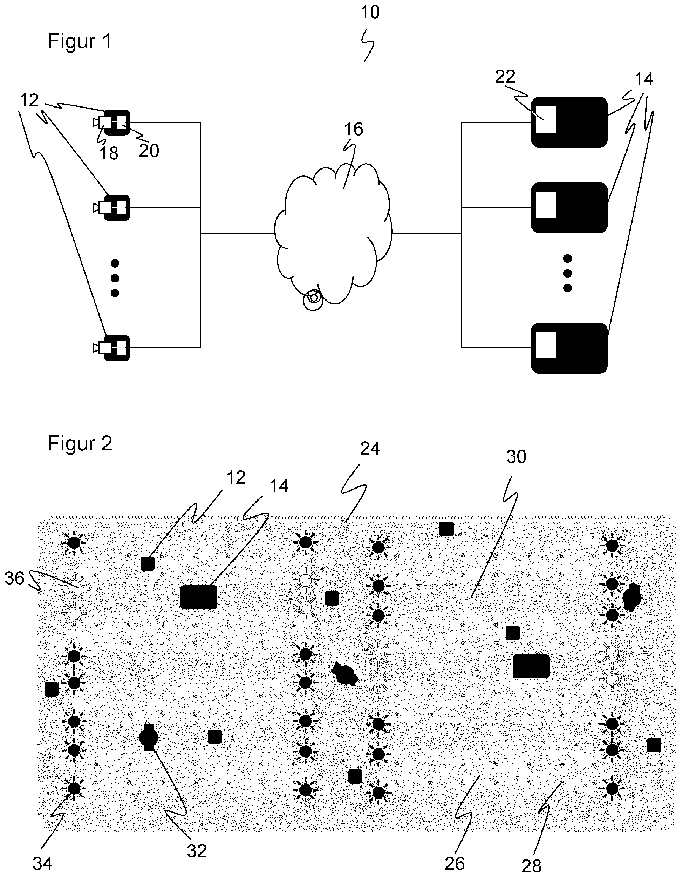

Figur 1 zeigt eine Darstellung eines Systems 10 mit einer Vielzahl von Aufklärungseinheiten 12 und Arbeitseinheiten 14, die mit einer hier als Cloud 16 dargestellten übergeordneten Steuerung verbunden sind. Aufklärungseinheiten 12 und Arbeitseinheiten 14 sind jeweils autonome Fahrzeuge oder autonome mobile Roboter, unterscheiden sich aber grundlegend voneinander in ihrer Ausgestaltung und Funktion. Die Aufklärungseinheiten 12 sind klein und beweglich, vorzugsweise Micro-ARMs von unter einem Kilogramm Gewicht mit Abmessungen im Bereich einiger zehn Zentimeter, in der Höhe sogar nur einiger Zentimeter. Sie weisen mindestens einen Sensor 18 auf, insbesondere mindestens eine Kamera und/oder ein LIDAR, sowie eine jeweilige eigene Steuerung 20. Micro-ARMs sind ausdrücklich Fahrzeuge und fliegen nicht, wobei Ausführungsformen des Systems 10 denkbar sind, in denen ergänzend einige fliegende Drohnen beispielsweise in größerer Höhe einer Lagerhalle und damit ohne Kollisionsgefahr mit Personen oder Arbeitseinheiten 14 eingesetzt werden. Arbeitseinheiten 14 andererseits sind größere autonome Fahrzeuge (wie AGC, Autonomous Guided Container; AGV, Autonomous Guided Vehicle; AMR, Autonomous Mobile Robot), die Objekte, Material und dergleichen transportieren können. Von der inneren Struktur einer Arbeitseinheit 14 ist lediglich eine jeweilige eigene Steuerung 22 gezeigt, der sonstige Aufbau eines solchen autonomen Fahrzeugs ist an sich bekannt.

Die Funktion der Aufklärungseinheiten 12 ist, sich in einer Umgebung zu bewegen und dadurch ein Umgebungsmodell zu erfassen beziehungsweise aktuell zu halten. Vorzugsweise wird dafür eine Sensor-Edge-Cloud-Architektur eingesetzt, in der die einzelnen Funktionalitäten sinnvoll verteilt werden. Beispielsweise liegt das Umgebungsmodell in der Cloud 16. Die Auswertung der Sensordaten des mindestens einen eigenen Sensors 18 erfolgt schon jeweils in der Steuerung 20 einer Aufklärungseinheit 12, vorzugsweise mit Methoden der Edge AI, so dass jede Aufklärungseinheit 12 eigenständig mit den von ihr erfassten lokalen Veränderungen zu dem Umgebungsmodell in der Cloud 16 beiträgt. Die Funktion der Arbeitseinheiten 14 andererseits ist, unter Verwendung des Umgebungsmodells die Logistik für eine eigentliche Aufgabe der Anlage zu unterstützen. in dem das System 10 installiert ist, und dafür jeweils Objekte von einer Position zu einer anderen Position zu transportieren.

Mit Steuerung sind jeweils Recheneinheiten in beliebiger Hardware gemeint. Beispiele für eine Recheneinheit sind digitale Rechenbausteine wie ein Mikroprozessor oder eine CPU (Central Processing Unit), ein FPGA (Field Programmable Gate Array), ein DSP (Digital Signal Processor), ein ASIC (Application-Specific Integrated Circuit), ein Kl-Prozessor, eine NPU (Neural Processing Unit), eine GPU (Graphics Processing Unit), eine VPU (Video Processing Unit) oder dergleichen. Sie können als Computer beliebiger Bauart einschließlich Notebooks, Smartphones, Tablets, einer Steuerung im engeren Sinne in Form eines Geräts, als Edge-Device sowie als Teil eines lokalen Netzwerks oder einer Cloud zur Verfügung gestellt sein und untereinander beliebige Kommunikationsverbindungen nutzen, etwa I/O-Link, Bluetooth, WLAN, Wi-Fi, 3G/4G/5G und prinzipiell jeglicher industrietaugliche Standard.

Figur 2 zeigt eine Übersichtsdarstellung in Form einer sehr schematischen Draufsicht auf eine industrielle Umgebung 24 mit sich darin bewegenden Aufklärungseinheiten 12 und Arbeitseinheiten 14. Die Umgebung 24 ist beispielsweise eine Lagerhalle, eine Fabrikhalle oder ein Logistikzentrum. In diesem Beispiel handelt es sich um ein Hochregallager mit Regalen 26, die auf Füßen 28 stehen. Dazwischen sind Gänge 30 gebildet, die hier so schmal sind, dass sich dort nur jeweils eine Arbeitseinheit 14 bewegen kann.

Die Aufklärungseinheiten 12 können als Schwarm verstanden werden, der während einer ständigen Patrouillenfahrt die Umgebung mittels seines mindestens einen Sensors 18 wahrnimmt. Vorzugsweise setzt eine Aufklärungseinheit mindestens eine 2D-Kamera oder 3D-Kamera ein. Dabei kann vorteilhaft die Funktion einer deutlich kostenintensiveren 3D-Kamera durch eine 2D-Kamera übernommen werden, indem aus den 2D-Bildern eine 3D-Szene berechnet wird. Hierfür eignen sich insbesondere Verfahren der künstlichen Intelligenz oder etwas spezielle tiefe neuronale Netze. Eine besonders bevorzugte Form der Umgebungserzeugung basiert auf den einleitend erwähnten NeRFs (Neural Radiance Fields), wobei mittels inversem Rendering eine hochauflösende 3D-Szene aus nur wenigen 2D-Bildern erzeugt werden kann. Ein (instant) NeRFing kann mit Methoden der Edge Al direkt in der Steuerung 20 der Aufklärungseinheit 12 gelöst werden. Mechanismen, die von SLAM (Simultaneous Localization and Mapping) oder Visual SLAM (basierend auf Bildern) bekannt sind, dienen dazu, die jeweiligen Daten zusammenzufügen.

Auch kann die jeweilige Aufklärungseinheit 12 sich auf diese Weise lokalisieren und navigieren. Es geht aber bei dem Umgebungsmodell vorzugsweise um mehr als nur eine durch SLAM erzeugte Karte, nämlich die Erstellung einer Umgebungsvirtualisierung. Dazu zählen nicht nur mögliche Wege und Hindernisse, sondern Dinge wie eine vollständige 3D-Kontur, die Unterscheidung in feste und bewegliche Objekte, Arbeitseinheiten 14 und/oder Personen und andere semantische Kategorien.

Vorzugsweise wird während einer Inbetriebnahme ein anfängliches Umgebungsmodell als Referenz erfasst. Dabei bewegen sich die Aufklärungseinheiten 12 durch die Umgebung 24, dies aber in einer Phase, in der Personen keinen Zutritt haben und vorzugsweise auch die Arbeitseinheiten 14 stehen oder sich sogar außerhalb der Umgebung 24 befinden. Das anfängliche Umgebungsmodell kann anschließend segmentiert werden. Damit werden die schon angesprochenen semantischen Kategorien gewonnen, wie Hochregale, Ladebuchten, Säulen, Türen oder mögliche Fahrwege, ferner bewegliche Objekte wie Paletten, Kartonagen und, sofern nicht außerhalb geparkt, auch Anfangspositionen der Arbeitseinheiten 14.

Während des Betriebs wird das Umgebungsmodell aufgrund der Informationen der Aufklärungseinheiten 12 aktuell gehalten. Es kann zentral in der Cloud 16 und/oder dezentral per Schwarmintelligenz in den Aufklärungseinheiten 12 systematisch auf Veränderungen hin analysiert werden: Welche Fahrwege sind derzeit frei oder blockiert, wo befinden sich bewegliche Objekte einschließlich der Arbeitseinheiten 14, haben sich womöglich die feststehenden Objekte verändert. Speziell können Personen 32 detektiert und lokalisiert und als besondere und schützenswerte bewegliche Objekt in dem Umgebungsmodell hinterlegt.

Das jeweilige aktuelle Umgebungsmodell kann in einem übergeordneten System der Cloud 16 oder mit Zugriff auf das Umgebungsmodell der Cloud verwendet werden, um die Abläufe in der Umgebung 24 zu optimieren. Beispielsweise können die Routen der Arbeitseinheiten 14 so gewählt werden, dass sie der aktuellen Situation angepasst auf kurzem Weg zum Ziel führen und dabei möglichst wenig ausgewichen werden muss. Dabei werden dann beispielsweise freie Gänge 30 bevorzugt oder nur Regale 26 angefahren, in denen tatsächlich eine Ladung abgestellt werden kann oder ein aufzunehmendes Objekt vorhanden ist.

Denkbar sind ferner Hinweise für Personen 32 in der Umgebung 24. Beispielsweise zeigt ein grünes Lichtsignal 34 einen freien Gang 30 und ein rotes Lichtsignal 36 einen Gang 30 an, durch den derzeit eine Arbeitseinheit 14 fährt. Spiegelbildlich können Arbeitseinheiten 14 Gänge 30 mit einer erfassten oder aufgrund ihres bisherigen Bewegungsverhaltens vermuteten Person 32 meiden oder sogar pausieren, wenn sie in die Nähe einer Person 32 kommen. Dadurch werden gefahrbringende Situationen für Personen 32 von vorneherein vermieden. Auch pauschalere Reaktionen sind denkbar, etwa indem Personen 32 gezählt werden und das Fahrverhalten daran angepasst wird. Befindet sich ohnehin keine Person 32 in der Umgebung 24, muss auch keine Person 32 geschützt werden, während umgekehrt viele Personen 32 deutlich mehr Vorsicht angeraten sein lassen. Solche Informationen können in Behavior Driven Risk Assessments verwendet werden, um die Anforderungsrate einer Sicherheitsfunktion zu minimieren. Die Anlage der Umgebung 24 kann dann mit einem geringeren Sicherheitsniveau vor Unfällen geschützt werden, weil die Häufigkeit gefährlicher Situationen signifikant abgesenkt wird.

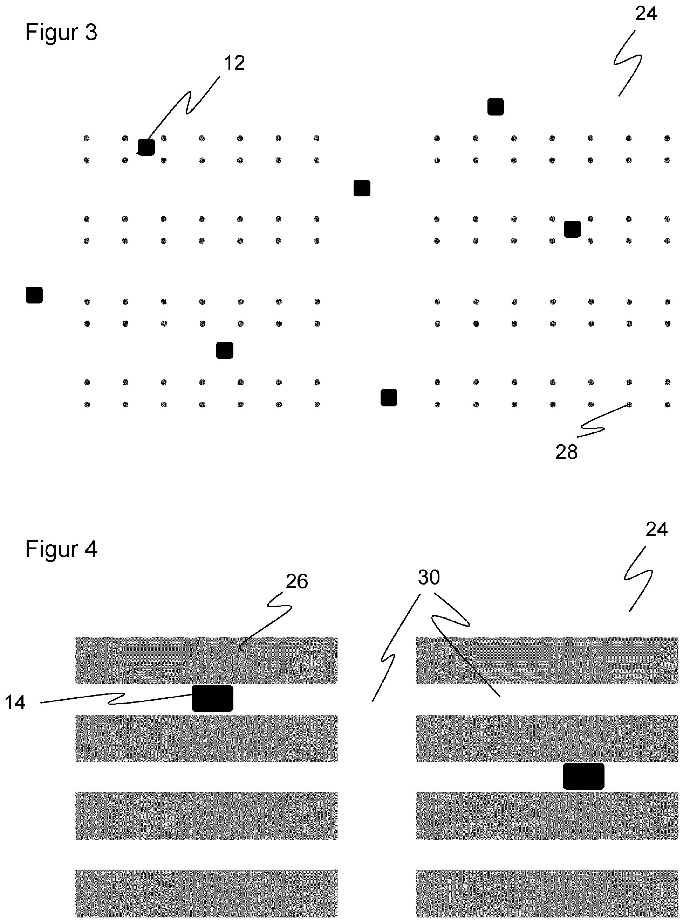

Figur 3 zeigt illustriert die Umgebung 24 nochmals aus Sicht der Aufklärungseinheiten 12. Für die Aufklärungseinheiten 12 ist die Umgebung 24 nahezu eine frei befahrbare Fläche. Lediglich die Füße 28 der Regale 26 stellen Hindernisse dar, die aber die Aufklärungseinheiten 12 überhaupt nicht daran hindern, unter den Regalen 26 hindurchzufahren. Dadurch können die Aufklärungseinheiten 12 die Umgebung 24 sehr effektiv und elegant erfassen. Dafür sind unterschiedlichste Bewegungsmuster denkbar, wie eine Art Brownsche Bewegung mit zufälligem oder quasi-zufälligem Verhalten der Aufklärungseinheiten 12 ebenso wie einem regelbasierten systematischen Abrastern eines Teilbereichs der Umgebung 24 oder der gesamten Umgebung 24, auf Rundwegen, Zick-Zack-Wegen oder durch Pirouetten-Fahrten.

Ist einmal eine Person 32 lokalisiert, so kann die entsprechende Aufklärungseinheit 12 in deren Nähe verharren und/oder mindestens eine Aufklärungseinheit 12 angefordert werden, um den Bereich um die Person 32 absichtlich mit erhöhter Intensität zu beobachten, dort also besonders hochwertige Informationen zu erfassen und diesen Bereich in dem Umgebungsmodell besonders oft zu aktualisieren. Das ist ein Beispiel dafür, dass die Aufklärungseinheiten 12 auch situativ reagieren können und ihre Fahrwege insbesondere ereignisbasiert wählen. Eine lokalisierte Person 32 steht dabei stellvertretend für ein auslösendes Ereignis, andere Anlässe könnten unerwartete Objekte, Hindernis in einem zuvor als frei angesehenen Fahrweg oder eine Arbeitseinheit 14 sein, die ein Problem wie verlorene Ladung oder eine Bewegungseinschränkung zeigt.

Aus Gründen des Datenschutzes kann es erwünscht sein, Personen 32 nur anonymisiert in das Umgebungsmodell aufzunehmen. Das lässt sich besonders elegant lösen, wenn die Aufklärungseinheiten 12 ihre Sensordaten dezentral und verteilt auswerten, sei es mittels Edge Al oder durch andere Verfahren. Dann wird an die Cloud 16 ein aktualisierter Abschnitt des Umgebungsmodells weitergegeben, der zwar erkennen lässt, dass es sich um eine Person 32 handelt, der aber deren Identifizierung nicht ermöglicht. Bei der ereignisbasierten Beobachtung einer Person 32 kann anstelle der Person 32 der umgebende Bereich gefilmt werden, was nicht nur das Datenschutzproblem löst, sondern auch weitere Informationen über mögliche Gefährdungen sowie anstehende Bewegungen und Tätigkeiten der Person 32 gibt.

Figur 4 zeigt komplementär zu Figur 3 eine Illustration der Umgebung 24 aus Sicht der Arbeitseinheiten 14. Die Regale 26 lassen nur sehr begrenzte Fahrwege in den Gängen 30 zu. Das ist keine fast frei befahrbare Fläche, sondern im Gegenteil eine nahezu nur eindimensionale Topologie, in der bei Störungen kaum oder nur schwer reagiert werden kann. Die Arbeitseinheiten 14 könnten keine den Aufklärungseinheiten 12 vergleichbare Aufklärungsarbeit leisten, sie sind zu unflexibel. Die Aufklärungseinheiten 12 sorgen über das Umgebungsmodell dafür, dass die Arbeitseinheiten 14 trotz ihrer vergleichsweise geringen Bewegungsfreiheit ihren Aufgaben effektiv nachkommen.

Die beiden unterschiedlichen Perspektiven der Aufklärungseinheiten 12 gemäß Figur 3 und der Arbeitseinheiten 14 gemäß Figur 4 illustrieren also nochmals besonders deutlich, welche Vorteile es hat, zwei Schwärme einzusetzen. Es sei noch angemerkt, dass die unterschiedlichen Rollen nicht verbieten, Arbeitseinheiten 14 mit Sensoren auszurüsten, über die sie zu dem Umgebungsmodell beitragen. Das wäre dann aber nur eine Ergänzung und kein Ersatz der Aufklärungseinheiten 12.

## Patentansprüche

1. Verfahren zum Erzeugen eines Umgebungsmodells einer Umgebung (24) in einer Industrie- oder Logistikanlage, wobei eine Vielzahl von über die Umgebung (24) verteilten Sensoren (18) einen jeweiligen lokalen Teilbereich der Umgebung (24) erfassen und daraus das Umgebungsmodell zusammengesetzt wird, wobei sich in der Umgebung (24) eine Vielzahl autonomer mobiler Aufklärungseinheiten (12) bewegen, insbesondere autonome mobile Roboter, und zumindest einige der Sensoren (18) Teil einer mobilen Aufklärungseinheit (12) sind und somit die Umgebung (24) an wechselnden Orten erfassen,
**dadurch gekennzeichnet, dass** die Aufklärungseinheiten (12) ein Gewicht von höchstens einem Kilogramm, laterale Abmessungen von höchstens 30 cm und/oder eine Höhe von höchstens 30 cm aufweisen, sich in der Umgebung (24) eine Vielzahl von mobilen Arbeitseinheiten (14) zum Transport von Nutzlasten bewegt und eine Arbeitseinheit (14) ein Vielfaches der Größe und/oder des Gewichts einer Aufklärungseinheit (12) aufweist.

2. Verfahren nach Anspruch 1,
wobei die Aufklärungseinheiten (12) laterale Abmessungen von höchstens 20 cm und/oder einer Höhe von höchstens 10 cm aufweisen.

3. Verfahren nach Anspruch 1 oder 2,
wobei die mobilen Arbeitseinheiten autonome Fahrzeuge oder autonome mobile Roboter sind.

4. Verfahren nach einem der vorhergehenden Ansprüche,
wobei die Arbeitseinheiten (24) sich in der Umgebung nur auf vorgesehenen Wegen (30) bewegen können, insbesondere in Gängen zwischen feststehenden Objekten oder Regalen (26).

5. Verfahren nach Anspruch 4,
wobei die Aufklärungseinheiten (12) nicht an die vorgesehenen Wege (30) gebunden sind, sich insbesondere unter einem Regal (26) hindurchbewegen können.

6. Verfahren nach einem der vorhergehenden Ansprüche,
wobei sich zumindest eine Aufklärungseinheit (12) zufällig oder regelbasiert, insbesondere zum Erfassen eines zugewiesenen Bereichs der Umgebung (24) oder der gesamten Umgebung (24), in der Umgebung (24) bewegt.

7. Verfahren nach einem der vorhergehenden Ansprüche,
wobei sich zumindest eine Aufklärungseinheit (12) in Reaktion auf ein Ereignis an eine dem Ereignis zugehörige Position in der Umgebung (24) bewegt, insbesondere zu einer Person (32), einer Arbeitseinheit (14) oder einem Hindernis.

8. Verfahren nach einem der vorhergehenden Ansprüche,
wobei die Bewegungen mindestens einiger der Aufklärungseinheiten (12) untereinander abgestimmt werden.

9. Verfahren nach einem der vorhergehenden Ansprüche,
wobei ein dreidimensionales Umgebungsmodell aus 2D-Aufnahmen der Sensoren (18) mittels eines neuronalen Netzes erzeugt wird, insbesondere mittels NeRF (Neural Radiance Fields).

10. Verfahren nach einem der vorhergehenden Ansprüche,
wobei die Aufklärungseinheiten (12) selbst aus ihren Sensordaten ein Teilmodell des Umgebungsmodells erzeugen, insbesondere ein anonymisiertes Teilmodell.

11. Verfahren nach einem der vorhergehenden Ansprüche,
wobei das Umgebungsmodell auf einem Edge-Device oder in einer Cloud (16) zusammengesetzt wird.

12. Verfahren nach einem der vorhergehenden Ansprüche,
wobei ein anfängliches Umgebungsmodell der Umgebung (24) erzeugt wird, insbesondere in einer Phase ohne Bewegung von Arbeitseinheiten (14) und/oder ohne Personen (32), und das anfängliche Umgebungsmodell insbesondere segmentiert wird.

13. Verfahren nach einem der vorhergehenden Ansprüche,
wobei die Aufklärungseinheiten (12) Personen (32) in der Umgebung (24) erkennen.

14. Verfahren nach einem der vorhergehenden Ansprüche,
wobei ein übergeordnetes System (16) in Abhängigkeit von dem Umgebungsmodell den Arbeitseinheiten (14) Fahrwege zuweist und/oder Personen (32) Hinweise (34, 36) auf Wege gibt.

15. System zum Erzeugen eines Umgebungsmodells einer Umgebung (24) in einer Industrie- oder Logistikanlage, wobei das System (10) eine Vielzahl von über die Umgebung (24) verteilte Sensoren (18) zum Erfassen eines jeweiligen lokalen Teilbereichs der Umgebung (24) aufweist und dafür ausgebildet ist, aus den Sensordaten der Sensoren (18) das Umgebungsmodell zusammenzusetzen, wobei das System (10) weiterhin eine Vielzahl autonomer mobiler Aufklärungseinheiten (12) aufweist, insbesondere autonome mobile Roboter, die sich in der Umgebung (24) bewegen, und zumindest einige der Sensoren (18) Teil einer mobilen Aufklärungseinheit (12) sind und somit die Umgebung (24) an wechselnden Orten erfassen,
**dadurch gekennzeichnet, dass**
die Aufklärungseinheiten (12) ein Gewicht von höchstens einem Kilogramm, laterale Abmessungen von höchstens 30 cm und/oder eine Höhe von höchstens 30 cm aufweisen, das System (10) eine Vielzahl von mobilen Arbeitseinheiten (14) zum Transport von Nutzlasten aufweist und eine Arbeitseinheit (14) ein Vielfaches der Größe und/oder des Gewichts einer Aufklärungseinheit (12) aufweist.

## Claims

1. A method of generating an environmental model of an environment (24) in an industrial plant or logistics plant, wherein a plurality of sensors (18) distributed over the environment (24) detect a respective local partial zone of the environment (24) and the environmental model is assembled therefrom,, wherein a plurality of autonomous mobile reconnaissance units (12), in particular autonomous mobile robots, move in the environment (24) and at least some of the sensors (18) are part of a mobile reconnaissance unit (12) and thus detect the environment (24) at changing locations,
**characterized in that**
the reconnaissance units (12 have a weight of at most one kilogram, lateral dimensions of at most 30 cm, and/or a height of at most 30 cm; **in that** a plurality of mobile work units (14) move in the environment (24) to transport payloads, and **in that** a work unit (14) has a multiple of the size and/or of the weight of a reconnaissance unit (12).

2. A method in accordance with claim 1,
wherein the reconnaissance units (12 have lateral dimensions of at most 20 cm and/or a height of at most 10 cm.

3. A method in accordance with claim 1 or claim 2,
wherein the work units are autonomous vehicles or autonomous mobile robots.

4. A method in accordance with claim 3,
wherein the work units (24) can only move on specified paths (30) in the environment, in particular in aisles between stationary object or racks (26).

5. A method in accordance with claim 4,
wherein the reconnaissance units (12) are not bound to the specified paths (30) and can in particular move beneath a rack (26).

6. A method in accordance with any one of the preceding claims,
wherein at least one reconnaissance unit (12) moves in the environment (24) randomly or in a rule-based manner, in particular to detect an assigned zone of the environment (24) or of the total environment (24).

7. A method in accordance with any one of the preceding claims,
wherein at least one reconnaissance unit (12) moves in response to an event to a position in the environment (24) associated with the event, in particular with a person (32), a work unit (14), or an obstacle.

8. A method in accordance with any one of the preceding claims,
wherein the movements of at least some of the reconnaissance units (12) are coordinated with one another.

9. A method in accordance with any one of the preceding claims,
wherein a three-dimensional environmental model is generated from 2D recordings of the sensors (18) by means of a neural network, in particular by means of NeRFs (neural radiance fields).

10. A method in accordance with any one of the preceding claims,
wherein the reconnaissance units (12) themselves generate a partial model of the environmental model, in particular an anonymized partial model, from their sensor data.

11. A method in accordance with any one of the preceding claims,
wherein the environmental model is assembled on an edge device or in a cloud (16).

12. A method in accordance with any one of the preceding claims,
wherein an initial environmental model of the environment (24) is generated, in particular in a phase without any movement of work units (14) and/or without persons (32), and the initial environmental model is in particular segmented.

13. A method in accordance with any one of the preceding claims,
wherein the reconnaissance units (12) recognize persons (32) in the environment (24).

14. A method in accordance with any one of the preceding claims,
wherein a superior system (16) assigns routes to the work units (14) and/or gives persons (32) indications (34, 36) of paths in dependence on the environmental model.

15. A system (10) for generating an environmental model of an environment (24) in an industrial plant or logistics plant, wherein the system (20) has a plurality of sensors (18) distributed over the environment (24) to detect a respective local partial zone of the environment (24) and is configured to assemble the environmental model from the sensor data of the sensors (18),
wherein the system (10) furthermore has a plurality of autonomous mobile reconnaissance units (12), in particular autonomous mobile robots, that move in the environment (24); and in that at least some of the sensors (18) are part of a mobile reconnaissance unit (12) and thus detect the environment (24) at changing locations,
**characterized in that**
the reconnaissance units (12 have a weight of at most one kilogram, lateral dimensions of at most 30 cm, and/or a height of at most 30 cm; **in that** a plurality of mobile work units (14) move in the environment (24) to transport payloads, and **in that** a work unit (14) has a multiple of the size and/or of the weight of a reconnaissance unit (12).

## Revendications

1. Procédé pour générer un modèle environnemental d'un environnement (24) dans une installation industrielle ou logistique,
dans lequel
une pluralité de capteurs (18) répartis sur l'environnement (24) détectent une zone partielle locale respective de l'environnement (24) pour en assembler le modèle environnemental,
une pluralité d'unités de reconnaissance mobiles autonomes (12), en particulier des robots mobiles autonomes, se déplacent dans l'environnement (24), et au moins quelques-uns des capteurs (18) font partie d'une unité de reconnaissance mobile (12) et détectent ainsi l'environnement (24) à divers endroits,
**caractérisé en ce que** les unités de reconnaissance (12) présentent un poids d'un kilogramme au maximum, des dimensions latérales de 30 cm au maximum et/ou une hauteur de 30 cm au maximum, une pluralité d'unités de travail mobiles (14) destinées à transporter des charges utiles se déplacent dans l'environnement (24), et une unité de travail (14) présente un multiple de la taille et/ou du poids d'une unité de reconnaissance (12).

2. Procédé selon la revendication 1,
dans lequel les unités de reconnaissance (12) ont des dimensions latérales de 20 cm au maximum et/ou une hauteur de 10 cm au maximum.

3. Procédé selon la revendication 1 ou 2,
dans lequel les unités de travail mobiles sont des véhicules autonomes ou des robots mobiles autonomes.

4. Procédé selon l'une des revendications précédentes,
dans lequel les unités de travail (24) ne peuvent se déplacer dans l'environnement que sur des chemins prévus (30), en particulier dans des couloirs entre des objets ou des étagères (26) fixes.

5. Procédé selon la revendication 4,
dans lequel les unités de reconnaissance (12) ne sont pas liées aux chemins prévus (30), en particulier, elles peuvent se déplacer sous une étagère (26).

6. Procédé selon l'une des revendications précédentes,
dans lequel au moins une unité de reconnaissance (12) se déplace dans l'environnement (24) de manière aléatoire ou sur la base de règles, en particulier pour détecter une zone attribuée de l'environnement (24) ou l'ensemble de l'environnement (24).

7. Procédé selon l'une des revendications précédentes,
dans lequel au moins une unité de reconnaissance (12) se déplace en réponse à un événement vers une position dans l'environnement (24) associée à l'événement, en particulier vers une personne (32), une unité de travail (14) ou un obstacle.

8. Procédé selon l'une des revendications précédentes,
dans lequel les mouvements d'au moins quelques-unes des unités de reconnaissance (12) sont coordonnés entre eux.

9. Procédé selon l'une des revendications précédentes,
dans lequel un modèle tridimensionnel de l'environnement est généré à partir de prises de vue 2D des capteurs (18) au moyen d'un réseau neuronal, en particulier au moyen de NeRF (Neural Radiance Fields).

10. Procédé selon l'une des revendications précédentes,
dans lequel les unités de reconnaissance (12) génèrent elles-mêmes un modèle partiel du modèle environnemental, en particulier un modèle partiel anonymisé, à partir de leurs données de capteur.

11. Procédé selon l'une des revendications précédentes,
dans lequel le modèle environnemental est assemblé sur un dispositif périphérique ou dans un nuage (16).

12. Procédé selon l'une des revendications précédentes,
dans lequel un modèle environnemental initial est généré de l'environnement (24), en particulier dans une phase sans déplacement d'unités de travail (14) et/ou sans personnes (32), et en particulier, le modèle environnemental initial est segmenté.

13. Procédé selon l'une des revendications précédentes,
dans lequel les unités de reconnaissance (12) détectent des personnes (32) dans l'environnement (24).

14. Procédé selon l'une des revendications précédentes,
dans lequel un système supérieur (16) attribue des chemins de déplacement aux unités de travail (14) en fonction du modèle environnemental et/ou donne aux personnes (32) des indications (34, 36) relatives aux chemins.

15. Système pour générer un modèle environnemental d'un environnement (24) dans une installation industrielle ou logistique,
le système (10) comprenant une pluralité de capteurs (18) répartis sur l'environnement (24) pour détecter une zone partielle locale respective de l'environnement (24) et étant conçu pour assembler le modèle environnemental à partir des données des capteurs (18),
le système (10) comprenant en outre une pluralité d'unités de reconnaissance mobiles autonomes (12), en particulier des robots mobiles autonomes, qui se déplacent dans l'environnement (24), et au moins quelques-uns des capteurs (18) font partie d'une unité de reconnaissance mobile (12) et détectent ainsi l'environnement (24) à divers endroits,
**caractérisé en ce que**
les unités de reconnaissance (12) présentent un poids d'un kilogramme au maximum, des dimensions latérales de 30 cm au maximum et/ou une hauteur de 30 cm au maximum, le système (10) comprend une pluralité d'unités de travail mobiles (14) destinées à transporter des charges utiles, et une unité de travail (14) présente un multiple de la taille et/ou du poids d'une unité de reconnaissance (12).
